# EUROPÄISCHE PATENTSCHRIFT

(11) **EP 1 545 000 B1**
(45) Veröffentlichungstag und Bekanntmachung des Hinweises auf die Patenterteilung: **29.08.2007**
(21) Anmeldenummer: 04090493.0
(22) Anmeldetag: 17.12.2004
(51) Int. Cl.: H03K 3/017

(54) **Schaltungsanordnung zur Regelung des Duty Cycle eines elektrischen Signals**
Circuit for regulating the duty cycle of an electrical signal
Circuit pour réguler le rapport cyclique d'un signal électrique

(30) Priorität: 19.12.2003 US 531005 P; 14.04.2004 US 824712
(43) Veröffentlichungstag der Anmeldung: 22.06.2005
(73) Patentinhaber: Infineon Technologies AG, 81669 München (DE)
(72) Erfinder: Doppke, Harald, 45481 Mühlheim/Ruhr (DE); Theil, Detlev, 11338 Stockholm (SE); Harms, Torsten, 47906 Kempen (DE); van Waasen, Stefan, 19248 Sollentuna (SE); Grewing, Christian, 19146 Sollentuna (SE)
(74) Vertreter: Müller, Wolfram Hubertus

(56) Entgegenhaltungen:
- US-A- 5 912 593
- US-A1- 2003 146 779

## Beschreibung

Die Erfindung betrifft eine Schaltungsanordnung zur Regelung des Duty Cycle eines elektrischen Signals. Sie findet insbesondere bei der Regelung des Duty Cycle von dynamischen Schnittstellensignalen in digitalen Kommunikationssystemen Anwendung.

### Hintergrund der Erfindung

Unter einem "Duty Cycle" wird in digitalen Kommunikationssystemen das An-/Aus-Verhältnis in einem elektrischen Signal bezeichnet. Insbesondere gibt der Duty Cycle an, zu welchem Prozentsatz ein High-Pegel in einem Signal vorhanden ist. Idealerweise liegt der Duty Cycle bei 50 Prozent bzw. 0,5.

Der Duty Cycle stellt ein wichtiges Kriterium dynamischer Schnittstellensignale in digitalen Kommunikationssystemen dar. Dynamische Schnittstellensignale sind insbesondere Einund Ausgangssignale digitaler Kommunikationskomponenten. Für den Duty Cycle gibt es im Allgemeinen sehr restriktive Spezifikationen, um die Funktion einzelner Komponenten in einem Gesamtsystem sicherzustellen. Je höher die Anzahl der Komponenten ist, umso mehr muss die Spezifikation eingeschränkt werden. Die Einhaltung dieser Spezifikation unter allen Randbedingungen wie Temperatur, Versorgungsspannung und Fertigungstoleranzen stellt häufig ein Problem dar.

Es ist bekannt, bei einer großen Anzahl von Systemkomponenten in einer Signalkette regelmäßig eine Retiming-Stufe (Clock-Recovery) einzubauen, um das Signal bezüglich seiner Anforderungen wieder zu regenerieren. Hierbei wird das Signal insbesondere bezüglich Jitter und Duty Cycle aufgefrischt. Solche Retiming-Stufen erfordern jedoch nachteilig einen erheblichen Aufwand an zusätzlichen System-Komponenten.

### Aufgabe der Erfindung

Der vorliegenden Erfindung liegt die Aufgabe zugrunde, eine Schaltungsanordnung zur Regelung des Duty Cycle eines elektrisches Signal zu Verfügung zu stellen, die in einfacher Weise eine Einstellung des Duty Cycle ermöglicht.

### Zusammenfassung der Erfindung

Die vorliegende Erfindung stellt eine Schaltungsanordnung bereit, die aufweist:
- einen ersten Eingangs-Differenzverstärker mit zwei Transistoren, der mit einem Eingangssignal beaufschlagt wird,
- eine erste Stromquelle zur Steuerung des Stroms durch den ersten Eingangs-Differenzverstärker,
- einen zweiten Eingangs-Differenzverstärker mit zwei Transistoren, der mit dem gleichen Eingangssignal beaufschlagt wird,
- eine zweiten Stromquelle zur Steuerung des Stroms durch den zweiten Eingangs-Differenzverstärker,
- eine Einrichtung, die aus den Strömen der beiden Eingangs-Differenzverstärker ein in seinem Pegel schwankendes Spannungssignal erzeugt,
- eine Buffer-Einrichtung, die das schwankende Spannungssignal in ein digitales Ausgangssignal umwandelt und einem Ausgang zuführt,
- eine Kapazität, und
- eine Einrichtung zum Laden und Entladen der Kapazität im Takt des digitalen Ausgangssignals,
- wobei die an der Kapazität anliegende Spannung der ersten und zweiten Stromquelle als Steuerspannung zugeführt ist und eine gegensinnige Regelung der beiden Stromquellen bewirkt.

Die erfindungsgemäße Schaltungsanordnung beruht auf dem Gedanken, die Stromquellen für die beiden Eingangs-Differenzverstärker derart zu regeln, dass das Ausgangssignal den gewünschten Duty Cycle aufweist, und das Ausgangssignal selbst dabei als Regelgröße zu verwenden. Über die Ströme durch die beiden Eingangs-Differenzverstärker können die Umschaltpunkte des betrachteten Signals sehr gut über weite Bereiche verschoben werden. Auch lassen sich die Schnelligkeit der Eingangs-Differenzverstärkerstufen und damit die Anstiegs- bzw. Abfallzeiten in Abhängigkeit von dem zur Verfügung gestellten Strom einstellen. Dabei ist zu beachten, dass die beiden Stromquellen durch die Kapazität gegensinnig geregelt werden: in dem Maße, in dem der Strom durch die eine Stromquelle zunimmt, nimmt der Strom durch die andere Stromquelle ab. Es wird gewissermaßen ein konstanter Strom in Abhängigkeit von der Regelung auf die beiden Stromquellen für die beiden Eingangs-Differenzverstärker aufgeteilt.

Einrichtungen zum Laden und Entladen einer Kapazität im Takt eines digitalen Signals sind aus US 2003146779 und US 5912593 bekannt.

Die erfindungsgemäße Lösung sieht vor, das eigentliche Ausgangssignal direkt zu regeln. Das Ausgangssignal stellt dabei eine Regelgröße für die Einrichtung zum Laden und Entladen der Kapazität im Takt des digitalen Ausgangssignals dar. Die an der Kapazität anliegende Spannung wird den Stromquellen für die Eingangs-Differenzverstärker als Stellgröße zugeführt. Die Stromquellen selbst stellen ein Stellglied der Regelung dar. Die Einrichtung zum Laden und Entladen der Kapazität stellt zusammen mit der Kapazität eine Regeleinrichtung dar.

Die erfindungsgemäße Lösung stellt eine Regelung über den kompletten relevanten Signalpfad bereit. So wird das Regelsignal auf die Stromquellen zur Steuerung des Stroms durch die beiden Eingangs-Differenzverstärker, an denen das Eingangssignal anliegt, geführt. Es erfolgt also eine Regelung vom Eingang bis zum Ausgang. Dies bedeutet, dass unmittelbar auch Ungenauigkeiten im Eingangssignal korrigiert und auch Eingangssignale mit schlechtem Duty Cycle rekonstruiert werden können. Dabei spielt es keine Rolle, ob das Ausgangssignal als Spannungs- oder als Stromsignal vorliegt. Des weiteren wird eine einfache Möglichkeit geschaffen, den Duty Cycle beliebig, d.h. auch auf andere Werte als 50 Prozent einzustellen.

In einer bevorzugten Ausgestaltung der Erfindung wird die Einrichtung zum Laden und Entladen der Kapazität im Takt des digitalen Ausgangssignals durch eine Ladungspumpe mit zwei Stromquellen bereitgestellt, wobei eine der Stromquellen die Kapazität lädt und die andere der Stromquellen die Kapazität entlädt. Der Wert des eingestellten Duty Cycle ergibt sich bei dieser Anordnung dabei direkt aus dem Verhältnis der Ladungspumpenströme zur Summe der Ladungspumpenströme, da im eingeregelten Fall die Summenladung auf die Kapazität null sein muss. Über die Ströme der beiden Ladungspumpen-Stromquellen lässt sich somit in einfacher Weise der Sollwert für den Duty Cycle festlegen.

In einer weiteren bevorzugten Ausgestaltung ist die Einrichtung, die aus den Strömen der beiden Eingangs-Differenzverstärker ein in seinem Pegel schwankendes Spannungssignal erzeugt, durch zwei Stromspiegelschaltungen gebildet, die jeweils einen Stromspiegel aus einem ersten Stromspiegel-Tansistor und einem zweiten Stromspiegel-Transistor aufweisen. Dabei sind ein Transistor des einen Stromspiegels und ein Transistor des anderen Stromspiegels miteinander verbunden. Das in seinen Pegel schwankende Spannungssignal wird zwischen diesen beiden Transistoren abgegriffen.

Insbesondere weist jede Stromspiegelschaltung auf: einen ersten Transistor, der gleich einem der Transistoren des jeweiligen Eingangs-Differenzverstärkers ist, und einen Stromspiegel aus einem ersten Stromspiegel-Transistor und einem zweiten Stromspiegel-Transistor mit einem Referenzstrom und einem Steuerstrom. Der Referenzstrom des Stromspiegels wird durch den vom ersten Transistor erzeugten Strom gebildet. Der erste Transistor und der erste Stromspiegel-Tansistor sind jeweils in Reihe geschaltet und die beiden zweiten Stromspiegel-Transistoren der beiden Stromspiegel miteinander verbunden. Zwischen diesen Transistoren wird dann das in seinem Pegel schwankende Spannungssignal abgegriffen.

Die Schaltungsanordnung weist eine Ausgangsstufe auf, die sowohl mit einem Stromausgang als auch mit einem Spannungsausgang realisiert sein kann.

### Kurze Beschreibung der Zeichnungen

Die Erfindung wird nachfolgend unter Bezugnahme auf die Figuren anhand eines Ausführungsbeispieles näher erläutert. Es zeigen:
- Figur 1: eine Schaltungsanordnung zur Regelung des Duty Cycle eines elektrischen Signals mit Stromausgang, und
- Figur 2: eine Schaltungsanordnung zur Regelung des Duty Cycle eines elektrischen Signals mit Spannungsausgang.

### Beschreibung mehrerer bevorzugter Ausführungsbeispiele

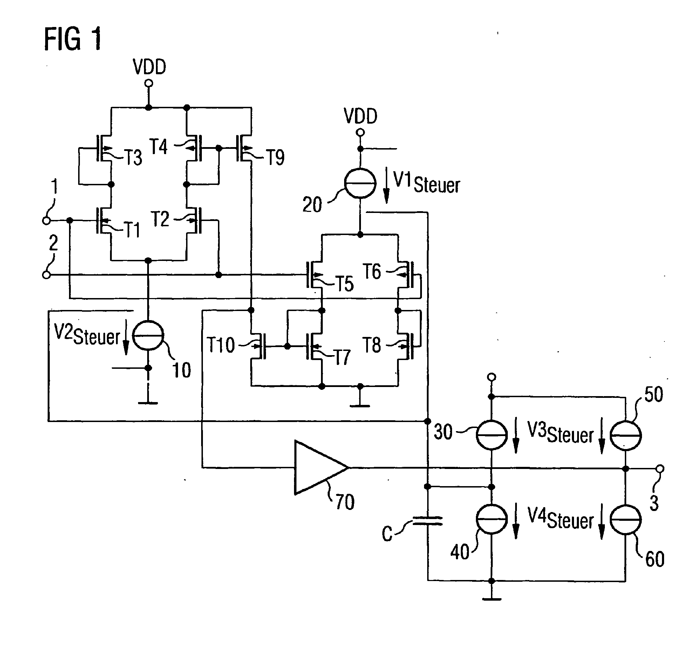

Die Figur 1 zeigt eine Schaltungsanordnung mit zwei Eingangs-Differenzverstärkern mit jeweils zwei Transistoren T1, T2 bzw. T5, T6. Bei den Transistoren T1, T2 handelt es sich um N-Kanal FET-(Feldeffekttransistor) Transistoren, bei den Transistoren T5, T6 um P-Kanal FET-Transistoren. Der Source-Anschluss der beiden Transistoren T1, T2 ist zusammengeschaltet und mit einer über eine Spannung V2_{Steuer} regelbaren Stromquelle 10 verbunden, deren anderes Ende mit Masse verbunden ist. Bei der regelbaren Stromquelle handelt es sich beispielsweise um einen FET-Transistor, wobei über die Gate-Spannung V2_{Steuer} der Strom der Stromquelle und damit durch den Differenzverstärker einstellbar ist.

In entsprechender Weise sind die Source-Anschlüsse der Transistoren T5, T6 des zweiten Eingangs-Differenzverstärkers über eine über eine Spannung V1_{Steuer} regelbare Stromquelle 20 mit der Betriebsspannung V_{DD} verbunden.

Es sei zunächst der erste Eingangs-Differenzverstärker betrachtet. In Reihe mit dem einen Transistor T1 des Differenzverstärkers ist ein P-Kanal FET Transistor T3 geschaltet, der eine aktive Last bereitstellt. Ebenso ist in Reihe mit dem anderen Transistor T2 des Eingangsdifferenzverstärkers ein P-Kanal FET Transistor T4 geschaltet, der ebenfalls eine aktive Last bereitstellt. Die Source-Anschlüsse der Transistoren T3, T4 sind mit der Betriebsspannung V_{DD} und die Drain-Anschlüsse der Transistoren T3, T4 mit den Drain-Anschlüssen der Transistoren T1, T2 verbunden.

Des weiteren wird mittels eines weiteren Transistors T9 ein Stromspiegel bereitgestellt. Der Transistor T9 ist ein P-Kanal FET-Transistor, dessen Source-Anschluss mit der positiven Betriebsspannung verbunden ist. Der Gate-Anschluss des Transistors T9 ist mit dem Gate-Anschluss des Transistors T4 verbunden. Gleichzeitig ist der Gate-Anschluss des Transistors T4 mit dem Drain-Anschluss des Transistors T2 verbunden. Es liegt eine an sich bekannte Stromspiegelschaltung vor.

Die Funktion des Stromspiegels ist wie folgt: Der durch den Transistor T2 erzeugte Strom stellt einen Referenzstrom des Stromspiegels dar, der durch den Transistor T4 fließt. Der Stromspiegel erzeugt nun einen Steuerstrom, der in einem bestimmten Verhältnis zum Referenzstrom steht, und der durch den Transistor T9 fließt.

Ein spiegelbildlicher Aufbau einer Stromspiegelschaltung ist bei dem zweiten Eingangs-Differenzverstärker mit den Transistoren T5, T6, T7, T8 und T10 gebildet. Bei den Transistoren T7, T8 und T10 handelt es sich jeweils um N-Kanal FET-Transistoren. Der Drain-Anschluss des Transistors T10 ist mit dem Drain-Anschluss des Transistors T9 verbunden.

Über zwei Eingangsklemmen 1, 2 wird den beiden Eingangs-Differenzverstärkern ein Eingangssignal zugeführt, das aus einer Abfolge von High- und Low-Spannungssignalen besteht, wobei das Eingangssignal möglicherweise eine schlechte Qualität aufweist und insbesondere nicht einen gewünschten Duty Cycle besitzt. Die beiden Eingangs-Differenzstufen werden durch das Eingangssignal derart gesteuert, dass bei einem High-Signal einer der Transistoren T2, T5 leitet, während der andere nicht leitet und bei einem Low-Signal der andere der Transistoren T5, T2 leitet, während der andere Transistor nicht leitet. Beispielsweise fließt bei einem High-Signal ein Strom durch die Transistoren T2, T4 und damit auch durch den einen Transistor T9 der Spiegelschaltung. Zur gleichen Zeit sperrt der Transistor T5 des anderen Eingangs-Differenzverstärkers.

Bei Vorliegen eines Low-Signals sperrt der Transistor T2 des ersten Eingangs-Differenzverstärkers, während der Transistor T5 des zweiten Eingangs-Differenzverstärkers leitet, so dass ein Strom durch die Transistoren T5, T7 und damit auch durch den Transistor T10 der Spiegelschaltung fließt.

Zwischen den Transistoren T9 und T10 wird eine Spannung abgegriffen. Diese Spannung schwankt zwischen einem Low-Wert und einem High-Wert entsprechend den mittels der Stromquellen 10, 20 bereitgestellten Ströme durch die jeweiligen Eingangs-Differenzverstärker, die die Ströme durch die Spiegelschaltungen bzw. die Transistoren T9, T10 bestimmen. Wenn der Transistor T9 leitet, sperrt der Transistor T10 und umgekehrt, so dass abwechselnd eine Spannung nahe oder gleich V_{DD} und nahe oder gleich der Masse-Spannung zwischen den beiden Transistoren T9, T10 abgegriffen wird.

Das abgegriffene Spannungssignal wird einer digitalen Buffer-Einrichtung 70 zugeführt, die das abgegriffene Spannungssignal in ein digitales Ausgangssignal umwandelt und einem Ausgang 3 der Schaltungsanordnung zuführt. Die Buffer-Einrichtung 70 dient dabei einer Isolation der nachfolgenden Ausgangsstufe von den vorangehenden Schaltungsteilen und einer Umwandlung des abgegriffenen Spannungssignals in ein digitales Signal. Das digitale Signal erfüllt anders als das zwischen den Transistoren T9, T10 abgegriffene Signal bestimmte Anforderungen an die Signalqualität, insbesondere an die Konstanz der Signalamplitude, Flankensteilheit und Jitter. Der digitale Buffer 70 umfasst dabei einen Komparator. Die Buffer-Einrichtung 70 kann mit oder ohne Signalinvertierung vorgesehen sein.

Die Schaltungsanordnung weist des weiteren eine Ausgangsstufe mit einem Stromausgang auf. Dieser wird durch Stromquellen 30, 40, 50, 60 gebildet. Die Stromquellen 50, 60 stellen eine erste Ladungspumpe bereit, die lediglich zum Bereitstellen eines Stroms am Ausgang 3 dienen. Die Ladungspumpe wird dabei direkt vom Ausgangssignal ausgesteuert. Eine weitere Ladungspumpe besteht aus zwei Stromquellen 30, 40, deren Ströme durch Steuerspannungen V3_{Steuer}, V4_{Steuer} gesteuert werden. Die eine Stromquelle 30 stellt einen Strom bereit, durch den eine Kapazität C geladen wird. Die andere Stromquelle 40 stellt einen Strom bereit, durch den die Kapazität C entladen wird. Das Laden und Entladen erfolgt dabei im Takt des Ausgangssignals der Buffer-Einrichtung 70.

Die Funktionsweise der Schaltungsanordnung wird im Folgenden erläutert. Dabei sei zunächst angenommen, dass die Spannungen V3_{Steuer}, V4_{Steuer} zur Steuerung der beiden Stromquellen 30, 40 der Ausgangsstufe identisch sind. Bei einem ausgeregelten Duty Cycle fließt im Mittel kein Strom auf die Kapazität C: die Ladeströme und die Entladeströme sind betragsmäßig gleich. Die Kapazität C wirkt als integrierendes Element, das eine langsame Regelcharakteristik aufweist. Die über der Kapazität C anliegende Spannung wird zum einen als Steuerspannung V1_{Steuer} der Stromquelle 20 des zweiten Eingangs-Differenzverstärkers und zum anderen als Steuerspannung V1ₛₜₑᵤₑᵣ der Stromquelle 10 des ersten Eingangs-Differenzverstärkers zugeführt.

Es sei angenommen, dass Eingangssignal weise einen Duty Cycle ungleich 50% auf. Dies führt dazu, dass aufgrund der Asymmetrie des Signals die Stromquellen 30, 40 der Ausgangsstufe die Kapazität C unterschiedlich lang laden oder entladen, so dass die Spannung über der Kapazität C ansteigt oder abfällt. Die sich ändernde Spannung wird als Stellsignal wie erläutert den Stromquellen 10, 20 für den ersten und zweiten Eingangs-Differenzverstärker zugeführt. Da die eine Stromquelle 10 mit Masse, die andere Stromquelle 20 mit der Betriebsspannung V_{DD} verbunden ist, ändert sich der Strom durch die Stromquellen 10, 20 bei einer sich ändernden Steuerspannung V1_{Steuer}, V2_{Steuer} gegensinnig: während der Strom durch die eine Stromquelle zunimmt, nimmt der Strom durch die andere Stromquelle ab und umgekehrt.

Über die Ströme lassen sich jedoch die Schnelligkeit der Eingangs-Differenzstufen und damit auch die Anstiegs- bzw. Abfallzeiten am Ausgang der Differenzstufe einstellen. Beispielsweise erhöht sich bei einem vergrößerten Strom an der Stromquelle 10 des ersten Eingangs-Differenzverstärkers die Schnelligkeit des ersten Eingangs-Differenzverstärkers, während bei der anderen Stromquelle 20 und dem anderen Eingangs-Differenzverstärker ein umgekehrtes Verhalten vorliegt.

Die Regelung führt dazu, dass der Duty Cylce auf einen Wert von 50 Prozent eingestellt wird. Dann fließt im Mittel kein Strom mehr auf die Kapazität C und das System ist ausgeregelt.

Sofern V3_{Steuer} ungleich V4_{Steuer} ist, d.h. die durch die Stromquellen 30, 40 bereitgestellten Stromsignale betragsmäßig nicht identisch sind, kann in einfacher Weise eine Duty Cycle Einstellung auf einen Wert ungleich 50 Prozent erfolgen. Der Wert des eingestellten Duty Cycle ergibt sich direkt aus dem Verhältnis der Ströme durch die beiden Stromquellen 30, 40 zur Summe dieser Ströme. Es wird also eine einfache Methode zur Einstellung des Sollwerts für den Duty Cycle bereitgestellt.

Es wird im übrigen noch auf Folgendes hingewiesen.

Grundlage für die Funktion der Schaltungsanordnung ist ein Spannungseingangssignal. Bei Nutzen eines Stromeingangssignals ist daher zusätzlich ein StromSpannungswandler am Eingang der Schaltungsanordnung zu verwenden.

Das Eingangssignal kann sowohl single-ended als auch differentiell sein. Bei einer differentiellen Ansteuerung liegen an den beiden Eingangsklemmen 1, 2 zueinander invertierte Eingangssignale an. Bei einer einphasigen (single-ended) Ansteuerung liegt ein Datensignal nur an einer Eingangsklemme an. Für diesen Fall muss der anderen Eingangsklemme eine entsprechende Referenzspannung zugeführt werden.

Die hier beschriebene Schaltungsvorrichtung ist bevorzugt in CMOS-Technologie ausgeführt. In äquivalenter Weise lassen sich jedoch auch entsprechende Schaltungen in BipolarTechnologie und in BiCMOS-Technologie ausführen.

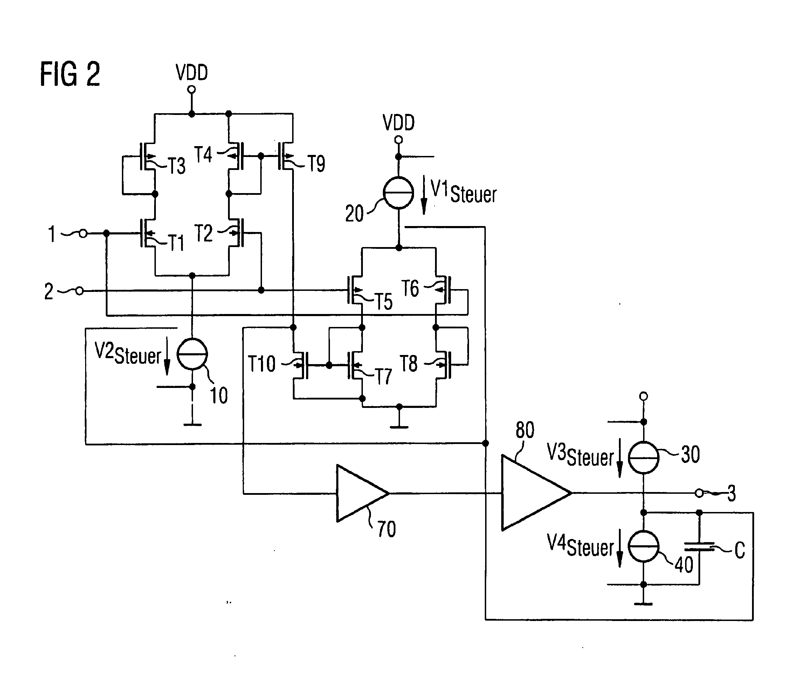

Die Schaltungsanordnung gemäß der Figur 2 unterscheidet sich nur insofern von der Schaltungsanordnung gemäß der Figur 1, als ein Spannungsausgang der Schaltungsanordnung vorgesehen ist. Dabei wird die Ladungspumpe 30, 40 zum Laden bzw. Entladen der Kapazität 10 direkt mit dem Ausgangssignal angesteuert. Ein Verstärker 80 sorgt für eine zusätzliche Spannungsverstärkung des Ausgangssignals des digitalen Buffers 70. Ansonsten bestehen keine Unterschiede zur Schaltungsanordnung der Figur 1, so dass auf die diesbezüglichen Ausführungen Bezug genommen wird.

## Patentansprüche

1. Schaltungsanordnung zur Regelung des Duty Cycle eines elektrischen Signals, aufweisend:
- einen ersten Eingangs-Differenzverstärker mit zwei Transistoren (T1, T2), der mit einem Eingangssignal beaufschlagt wird,
- eine erste Stromquelle (10) zur Steuerung des Stroms durch den ersten Eingangs-Differenzverstärker,
- einen zweiten Eingangs-Differenzverstärker mit zwei Transistoren (T5, T6), der mit dem gleichen Eingangssignal beaufschlagt wird,
- eine zweite Stromquelle (20) zur Steuerung des Stroms durch den zweiten Eingangs-Differenzverstärker,
- eine Einrichtung (T2, T4, T9; T5, T7, T10), die aus den Strömen der beiden Eingangs-Differenzverstärker ein in seinem Pegel schwankendes Spannungssignal erzeugt,
- eine Buffer-Einrichtung (70), die das schwankende Spannungssignal in ein digitales Ausgangssignal umwandelt und einem Ausgang zuführt,
- eine Kapazität (C),
- eine Einrichtung (30, 40) zum Laden und Entladen der Kapazität im Takt des digitalen Ausgangssignals,
- wobei die an der Kapazität (C) anliegende Spannung der ersten und zweiten Stromquelle (10, 20) als Steuerspannung zugeführt ist und eine gegensinnige Regelung der beiden Stromquellen (10, 20) bewirkt.

2. Schaltungsanordnung nach Anspruch 1, wobei der erste Eingangs-Differenzverstärker zwei n-Kanal FET Transistoren (T1, T2) aufweist und die erste Stromquelle (10) zwischen Masse und den Source-Anschlüssen der Transistoren (T1, T2) des ersten Eingangs-Differenzverstärkers angeordnet ist.

3. Schaltungsanordnung nach Anspruch 1, wobei der zweite Eingangs-Differenzverstärker zwei p-Kanal FET Transistoren (T5, T6) aufweist und die zweite Stromquelle (20) zwischen einer Betriebsspannung und den Source-Anschlüssen der Transistoren (T5, T6) des zweiten Eingangs-Differenzverstärkers angeordnet ist.

4. Schaltungsanordnung nach Anspruch 1, wobei die Einrichtung zum Laden und Entladen der Kapazität durch eine Ladungspumpe mit einer ersten Stromquelle (30), die die Kapazität lädt, und einer zweiten Stromquelle (40), die die Kapazität entlädt, gebildet ist, wobei bei Vorliegen eines High-Signals eine der beiden Stromquellen (10, 20) und bei Vorliegend eines Low-Signals die andere der beiden Stromquellen (20, 10) aktiviert ist und die Kapazität (C) lädt bzw. entlädt.

5. Schaltungsanordnung nach Anspruch 1, wobei die Einrichtung, die aus den Strömen der beiden Eingangs-Differenzverstärker ein in seinem Pegel schwankendes Spannungssignal erzeugt, durch zwei Stromspiegelschaltungen (T2, T4, T9; T5, T7, T10) gebildet ist, die jeweils einen Stromspiegel aus einem ersten Stromspiegel-Tansistor (T4; T7) und einem zweiten Stromspiegel-Transistor (T9; T10) aufweisen, und ein Transistor (T9) des einen Stromspiegels und ein Transistor (T10) des anderen Stromspiegels miteinander verbunden sind, wobei das in seinen Pegel schwankende Spannungssignal zwischen diesen beiden Transistoren (T9, T10) abgegriffen wird.

6. Schaltungsanordnung nach Anspruch 5, wobei jede Stromspiegelschaltung aufweist:
- einen ersten Transistor (T2; T5), der gleich einem der Transistoren des jeweiligen Eingangs-Differenzverstärkers ist,
- einen Stromspiegel aus einem ersten Stromspiegel-Transistor (T4; T8) und einem zweiten Stromspiegel-Transistor (T9; T10) mit einem Referenzstrom und einem Steuerstrom, wobei
- der Referenzstrom des Stromspiegels durch den vom ersten Transistor (T2; T5) erzeugten Strom gebildet wird,
- der erste Transistor (T2; T5) und der erste Stromspiegel-Tansistor (T4; T8) in Reihe geschaltet sind, und
- jeweils die beiden zweiten Stromspiegel-Transistoren (T9; T10) der beiden Stromspiegel miteinander verbunden und zwischen diesen Transistoren (T9, T10) das in seinem Pegel schwankende Spannungssignal abgegriffen wird.

7. Schaltungsanordnung nach Anspruch 1, wobei eine Ausgangsstufe mit einem Stromausgang vorgesehen ist.

8. Schaltungsanordnung nach Anspruch 1, wobei eine Ausgangsstufe mit einem Spannungsausgang vorgesehen ist.

9. Schaltungsanordnung nach Anspruch 1, wobei die einzelnen Transistoren in CMOS-Technologie, als Bipolartransistoren oder in BiCMOS-Technologie ausgeführt sind.

## Claims

1. Circuit arrangement for regulating the duty cycle of an electrical signal having:
- a first input differential amplifier with two transistors (T1, T2), to which an input signal is applied,
- a first current source (10) for controlling the current through the first input differential amplifier,
- a second input differential amplifier with two transistors (T5, T6), to which the same input signal is applied,
- a second current source (20) for controlling the current through the second input differential amplifier,
- a device (T2, T4, T9; T5, T7, T10) which generates a voltage signal from the currents of the two input differential amplifiers, the level of which voltage signal fluctuates,
- a buffer device (70), which converts the fluctuating voltage signal into a digital output signal and leads to an output,
- a capacitance (C),
- a device (30, 40) for charging and discharging the capacitance in time with the digital output signal,
- the voltage present at the capacitance (C) being fed to the first and second current sources (10, 20) as control voltage and effecting regulation of the two current sources (10, 20) in opposite senses.

2. Circuit arrangement according to Claim 1, the first input differential amplifier having two n-channel FET transistors (T1, T2) and the first current source (10) being arranged between earth and the source terminals of the transistors (T1, T2) of the first input differential amplifier.

3. Circuit arrangement according to Claim 1, the second input differential amplifier having two p-channel FET transistors (T5, T6) and the second current source (20) being arranged between an operating voltage and the source terminals of the transistors (T5, T6) of the second input differential amplifier.

4. Circuit arrangement according to Claim 1, the device for charging and discharging the capacitance being formed by a charge pump with a first current source (30), which charges the capacitance, and a second current source (40), which discharges the capacitance, one of the two current sources (10, 20) being activated given the presence of a high signal and the other of the two current sources (20, 10) being activated given the presence of a low signal and respectively charging and discharging the capacitance (C).

5. Circuit arrangement according to Claim 1, the device which generates a voltage signal from the currents of the two input differential amplifiers, the level of which voltage signal fluctuates, being formed by two current mirror circuits (T2, T4, T9; T5, T7, T10) each having a current mirror comprising a first current mirror transistor (T4; T7) and a second current mirror transistor (T9; T10), and a transistor (T9) of one current mirror and a transistor (T10) of the other current mirror being connected to one another, the voltage signal whose level fluctuates being tapped off between these two transistors (T9, T10).

6. Circuit arrangement according to Claim 5, each current mirror circuit having:
- a first transistor (T2; T5), which is identical to one of the transistors of the respective input differential amplifier,
- a current mirror comprising a first current mirror transistor (T4; T8) and a second current mirror transistor (T9; T10) with a reference current and a control current,
- the reference current of the current mirror being formed by the current generated by the first transistor (T2; T5),
- the first transistor (T2; T5) and the first current mirror transistor (T4; T8) being connected in series and
- in each case the two second current mirror transistors (T9; T10) of the two current mirrors being connected to one another and the voltage signal whose level fluctuates being tapped off between these transistors (T9, T10).

7. Circuit arrangement according to Claim 1, an output stage with a current output being provided.

8. Circuit arrangement according to Claim 1, an output stage with a voltage output being provided.

9. Circuit arrangement according to Claim 1, the individual transistors being embodied in CMOS technology, as bipolar transistors or in BiCMOS technology.

## Revendications

1. Circuit pour la régulation du rapport cyclique d'un signal électrique, comportant :
- un premier amplificateur différentiel d'entrée qui comporte deux transistors (T1, T2) et qui reçoit un signal d'entrée,
- une première source de courant (10) pour la commande du courant dans le premier amplificateur différentiel d'entrée,
- un deuxième amplificateur différentiel d'entrée qui comporte deux transistors (T5, T6) et qui reçoit le même signal d'entrée,
- une deuxième source de courant (20) pour la commande du courant dans le deuxième amplificateur différentiel d'entrée,
- un dispositif (T2, T4, T9 ; T5, T7, T10) qui produit à partir des courants des deux amplificateurs différentiels d'entrée un signal de tension de niveau variable,
- un dispositif tampon (70) qui convertit le signal de tension variable en un signal de sortie numérique et qui envoie celui-ci à une sortie,
- une capacité (C),
- un dispositif (30, 40) pour le chargement et le déchargement de la capacité selon le cycle du signal de sortie numérique,
- la tension présente à la capacité (C) étant envoyée à la première et à la deuxième source de courant (10, 20) comme tension de commande et provoquant une régulation en sens contraire des deux sources de courant (10, 20).

2. Circuit selon la revendication 1, dans lequel le premier amplificateur différentiel d'entrée comporte deux transistors FET à canal n (T1, T2) et dans lequel la première source de courant (10) est placée entre la masse et les bornes de source des transistors (T1, T2) du premier amplificateur différentiel d'entrée.

3. Circuit selon la revendication 1, dans lequel le deuxième amplificateur différentiel d'entrée comporte deux transistors FET à canal p (T5, T6) et dans lequel la deuxième source de courant (20) est placée entre la masse et les bornes de source des transistors (T5, T6) du deuxième amplificateur différentiel d'entrée.

4. Circuit selon la revendication 1, dans lequel le dispositif pour le chargement et le déchargement de la capacité est formé par une pompe de charge avec une première source de courant (30) qui charge la capacité et avec une deuxième source de courant (40) qui décharge la capacité, l'une des deux sources de courant (10, 20) étant activée en présence d'un signal haut et l'autre des deux sources de courant (20, 10) étant activée en présence d'un signal bas et la capacité (C) se chargeant respectivement se déchargeant alors.

5. Circuit selon la revendication 1, dans lequel le dispositif qui produit à partir des courants des deux amplificateurs différentiels d'entrée un signal de tension de niveau variable est formé par deux circuits formant miroirs de courant (T2, T4, T9 ; T5, T7, T10) qui comportent chacun un miroir de courant constitué d'un premier transistor de miroir de courant (T4 ; T7) et d'un deuxième transistor de miroir de courant (T9 ; T10) et dans lequel un transistor (T9) d'un miroir de courant et un transistor (T10) de l'autre miroir de courant sont reliés entre eux, le signal de tension de niveau variable étant alors prélevé entre ces deux transistors (T9, T10).

6. Circuit selon la revendication 5, dans lequel chaque circuit miroir de courant comporte :
- un premier transistor (T2 ; T5), qui est identique à l'un des transistors de l'amplificateur différentiel d'entrée respectif,
- un miroir de courant constitué d'un premier transistor de miroir de courant (T4 ; T8) et d'un deuxième transistor de miroir de courant (T9 ; T10) avec un courant de référence et avec un courant de commande,
- le courant de référence du miroir de courant étant formé par le courant produit par le premier transistor (T2 ; T5),
- le premier transistor (T2 ; T5) et le premier transistor de miroir de courant (T4 ; T8) étant branchés en série, et
- à chaque fois, les deux transistors de miroir de courant (T9; T10) des deux miroirs de courant étant reliés entre eux et le signal de tension de niveau variable étant prélevé entre ces transistors (T9, T10).

7. Circuit selon la revendication 1, dans lequel il est prévu un étage de sortie avec une sortie de courant.

8. Circuit selon la revendication 1, dans lequel il est prévu un étage de sortie avec une sortie de tension.

9. Circuit selon la revendication 1, dans lequel les différents transistors sont réalisés en technologie CMOS, comme transistors bipolaires ou en technologie BiCMOS.
